# EUROPÄISCHE PATENTSCHRIFT

(11) **EP 1 303 883 B1**
(45) Veröffentlichungstag und Bekanntmachung des Hinweises auf die Patenterteilung: **03.11.2010**
(21) Anmeldenummer: 01953923.8
(22) Anmeldetag: 13.07.2001
(51) Int. Cl.: H01L 29/861, H01L 29/812, H01L 29/808, H01L 29/78

(54) **HALBLEITERAUFBAU MIT VERGRABENEM INSELGEBIET UND KONTAKTGEBIET**
SEMICONDUCTOR ARRANGEMENT WITH BURIED ISLAND AND CONTACT REGIONS
STRUCTURE A SEMI-CONDUCTEURS A ILOT ET ZONE DE CONTACT ENTERRES

(30) Priorität: 25.07.2000 DE 10036208
(43) Veröffentlichungstag der Anmeldung: 23.04.2003
(73) Patentinhaber: SiCED Electronics Development GmbH & Co KG, 91052 Erlangen (DE)
(72) Erfinder: FRIEDRICHS, Peter, 90475 Nürnberg (DE); MITLEHNER, Heinz, 91080 Uttenreuth (DE); SCHÖRNER, Reinhold, 91091 Grossenseebach (DE)
(74) Vertreter: Maier, Daniel Oliver
(86) Internationale Anmeldenummer: PCT/DE2001/002640
(87) Internationale Veröffentlichungsnummer: WO 2002/009195

(56) Entgegenhaltungen:
- WO-A-00/03440
- WO-A-00/16403
- WO-A-98/19342

## Beschreibung

Die Erfindung betrifft einen Halbleiteraufbau zur Steuerung eines Stromflusses. Der erfindungsgemäße Halbleiteraufbau umfasst insbesondere ein in einem ersten Halbleitergebiet zumindest teilweise vergrabenes Inselgebiet.

Zum Versorgen eines elektrischen Verbrauchers mit einem elektrischen Nennstrom wird der Verbraucher üblicherweise über ein Schaltgerät an ein elektrisches Versorgungsnetz geschaltet. Beim Einschaltvorgang und auch im Falle eines Kurzschlusses tritt ein Überstrom auf, der deutlich über dem Nennstrom liegt. Zum Schutz des elektrischen Verbrauchers muss das zwischen den Verbraucher und das elektrische Netz geschaltete Schaltgerät diesen Überstrom begrenzen und auch abschalten können. Für diese Funktion sind strombegrenzende Schalter in Form eines Halbleiteraufbaus bekannt.

Aus der US 6,034,385 sowie aus der WO 00/16403 A1 ist ein solcher Halbleiteraufbau bekannt, in dem ein Stromfluss zwischen einer ersten und einer zweiten Elektrode gesteuert wird. Insbesondere wird der Strom ein- und ausgeschaltet oder auf einen maximalen Wert begrenzt. Der aktive Teil des Halbleiteraufbaus besteht aus einem ersten Halbleitergebiet eines vorgegebenen Leitungstyps, insbesondere des n-Leitungstyps. Zur Stromsteuerung ist innerhalb des ersten Halbleitergebiets mindestens ein laterales Kanalgebiet vorgesehen. Unter lateral wird hierbei eine Richtung parallel zu einer Oberfläche des ersten Halbleitergebiets verstanden. Vertikal wird dagegen eine senkrecht zur Oberfläche verlaufende Richtung bezeichnet. Das laterale Kanalgebiet wird durch mindestens einen p-n-übergang, insbesondere durch die Verarmungszone (Zone mit Verarmung an Ladungsträgern und damit hohem elektrischen Widerstand; Raumladungszone) dieses p-n-Übergangs, in vertikaler Richtung begrenzt. Die vertikale Ausdehnung dieser Verarmungszone kann unter anderem durch eine Steuerspannung eingestellt werden. Der p-n-Übergang ist zwischen dem ersten Halbleitergebiet und einem vergrabenen p-leitenden Inselgebiet gebildet. Das vergrabene Inselgebiet übernimmt die Abschirmung der ersten Elektrode gegenüber dem hohen elektrischen Feld in Sperrrichtung oder im ausgeschalteten Zustand. Bei speziellen Ausführungsformen kann das Kanalgebiet auch durch eine weitere Verarmungszone in vertikaler Richtung begrenzt werden. Diese weitere Verarmungszone wird beispielsweise durch einen weiteren p-n-Übergang zwischen einem zweiten p-leitenden Halbleitergebiet und dem ersten n-leitenden Halbleitergebiet hervorgerufen. Je nach Ausführungsform kann sich bei dem bekannten Halbleiteraufbau ein relativ hoher Durchlasswiderstand ergeben. Außerdem ist zur exakten Einstellung der lateralen Abmessung des Kanalgebiets sowie zur genauen lateralen Positionierung des Kanalgebiets innerhalb des Halbleiteraufbaus eine sehr exakt aufeinander bezogene Positionierung der einzelnen Halbleitergebiete erforderlich. Dieser hohe Justageaufwand ist insbesondere für das vergrabene p-leitende Inselgebiet und das zweite p-leitende Halbleitergebiet notwendig.

Ein ähnlicher Halbleiteraufbau wird in der DE 196 29 088 A1 beschrieben. Folglich hat auch dieser Halbleiteraufbau einen relativ hohen Durchlasswiderstand, und es sind wiederum hohe Anforderungen an die Justagegenauigkeit zu erfüllen.

Weiterhin wird mit der US 5,543,637 ein Halbleiteraufbau offenbart, der ein erstes Halbleitergebiet eines ersten Leitungstyps mit einem vergrabenen Inselgebiet eines zum ersten entgegengesetzten Leitungstyps sowie zwei Elektroden und einer Steuerelektrode umfasst. Die durch die Steuerelektrode und das vergrabene Inselgebiet hervorgerufenen jeweiligen Verarmungszonen bilden wieder ein Kanalgebiet, in dem ein zwischen den beiden Elektroden fließender Strom gesteuert wird. Die Steuerelektrode ist entweder als Schottky-Kontakt oder als MOS-Kontakt ausgeführt. Als Halbleitermaterial wird 3C-, 6H oder 4H-Siliciumcarbid verwendet. Auch dieser Halbleiteraufbau weist einen relativ hohen Durchlasswiderstand auf und erfordert eine hohe Präzision bei der Justierung der einzelnen Halbleitergebiete.

Die WO 00/03440 A1 beschreibt insbesondere ein als HCBG - Transistor (Horizontal Channel Buffered Gate Transistor) bezeichnetes SiC-Halbleiterbauelement. Da die Gate-Elektrode dieses Transistors nicht auf einer Isolatorschicht, sondern unmittelbar auf einer beispielsweise p-dotierten SiC-Kontaktschicht angeordnet ist, lassen sich die in konventionellen MOSFET's und ACCUFET'S durch Fowler-Nordheim-Ströme hervorgerufenen, u.U. zur Zerstörung des jeweiligen Bauelements führenden Effekte weitgehend unterdrücken. Die aus Gate-Elektrode und Gate-Kontaktschicht bestehende Struktur erstreckt sich hierbei soweit in Richtung des der Source-Elektrode zugeordneten Source-Kontaktes, dass sie mit einer in die n⁻-dotierte Driftzone des Transistors eingebetteten, p⁺-dotierten Basisregion in vertikaler Richtung teilweise überlappt. Das nach oben von der Gate-Kontaktschicht und nach unten von der Basisregion begrenzte Halbleitervolumen bildet einen in horizontaler Richtung verlauffenden Kanal als Teil des Strompfades zwischen Source-Elektrode und Drain-Elektrode, wobei der Überlapp zwischen der Gate-Kontaktschicht und der Basisregion die Länge dieses Kanals definiert. Da die Abmessungen (Querschnitt, Länge) des horizontalen Kanalabschnitts und dessen Lage innerhalb der Halbleiterstruktur die elektrischen Eigenschaften, insbesondere das Steuer- und Schaltverhalten des HCBG-Transistors entscheidend beeinflussen, ist dessen Herstellung auf Grund der Vielzahl der vorzunehmenden Justierschritte und der dabei jeweils einzuhaltenden, sehr engen Toleranzen mit einem erheblichen Aufwand an Kosten und Zeit verbunden.

Der Erfindung liegt die Aufgabe zu Grunde, einen einen niedrigen Durchlasswiderstand aufweisenden Halbleiteraufbau zur passiven Beeinflussung oder aktiven Steuerung eines durch den Halbleiteraufbau fließenden Stromes anzugeben. Gleichzeitig soll der für die lokale Definition des Kanalgebiets erforderliche Justageaufwand gegenüber dem Stand der Technik verringert werden.

Diese Aufgabe wird durch einen Halbleiteraufbau gelöst, der die im unabhängigen Patentanspruch 1 angegebenen Merkmale aufweist.

Die Erfindung beruht dabei auf der Erkenntnis, dass der bei dem bekannten Halbleiteraufbau zu beobachtende relativ hohe Durchlasswiderstand insbesondere durch einen sogenannten Vorkanal hervorgerufen wird. Dieser Vorkanal befindet sich zwischen dem eigentlichen lateralen Kanalgebiet und dem Kontaktgebiet innerhalb des ersten Halbleitergebiets. Da das erste Halbleitergebiet üblicherweise einen großen Teil der in Sperrrichtung oder im ausgeschalteten Zustand anfallenden Spannung aufzunehmen hat, weist es normalerweise eine relativ niedrige Dotierungsrate auf. Dies hat jedoch eine vergleichsweise niedrige elektrische Leitfähigkeit zur Folge. Der im Durchlasszustand geführte elektrische Strom erfährt deshalb einen umso größeren elektrischen Widerstand, je länger sein Strompfad durch das erste Halbleitergebiet ist. Durch die Anordnung des Kontaktgebiets innerhalb des vergrabenen Inselgebiets tritt ein aus dem Kontaktgebiet herausfließender elektrischer Strom unmittelbar in das für die Stromsteuerung maßgebliche laterale Kanalgebiet ein. Ein für die eigentliche Stromsteuerung unerheblicher Vorkanal, der ansonsten zu einer unerwünschten Anhebung des Durchlasswiderstands führen würde, ergibt sich bei dieser besonderen Anordnung des Kontaktgebiets nicht. Damit liegt der insgesamt resultierende Durchlasswiderstand deutlich unter dem des bekannten Halbleiteraufbaus.

Das laterale Kanalgebiet wird sowohl in seiner lateralen Abmessung als auch in seiner lateralen Position innerhalb des Halbleiteraufbaus im Wesentlichen durch die Lage des Kontaktgebiets innerhalb des vergrabenen Inselgebiets bestimmt. Es wurde erkannt, dass sich das ursprünglich für einen MOSFET konzipierte Strukturierungsverfahren der *WO 99*/*07011 A1* mit Vorteil auch für die Definition des lateralen Kanalgebiets des Halbleiteraufbaus verwenden lässt. Günstig wirkt sich hierbei insbesondere aus, dass das Kontaktgebiet und das Inselgebiet, die die Abmessung und die Lage des lateralen Kanalgebiets bestimmen, in der gleichen Epitaxieschicht angeordnet sind. Dagegen befinden sich bei dem bekannten Halbleiteraufbau die das laterale Kanalgebiet definierenden Strukturen in mindestens zwei verschiedenen Epitaxieschichten. Dadurch kann zwischen zwei für die Strukturdefinition erforderlichen Lithographieschritten insbesondere ein Epitaxiewachstum stattfinden, wodurch eine hochgenaue Justierung der Lithographieschritte in Bezug zueinander erheblich erschwert wird. Durch die Einbettung des Kontaktgebiets in das Inselgebiet erfolgt die für das laterale Kanalgebiet wesentliche Strukturierung bei dem Halbleiteraufbau innerhalb einer einzigen Epitaxieschicht und damit sowohl mit geringerem Aufwand als auch mit einer sehr hohen Präzision.

Vorteilhafte Ausgestaltungen des Halbleiteraufbaus gemäß der Erfindung ergeben sich aus den vom Anspruch 1 abhängigen Ansprüchen.

In einer vorteilhaften Ausführungsform werden das Inselgebiet und das Kontaktgebiet mittels einer ersten Elektrode kurzgeschlossen. Dazu ist in dem ersten Halbleitergebiet ein Kontaktloch vorgesehen, das sich ausgehend von der ersten Oberfläche bis mindestens zur zweiten Oberfläche erstreckt. Es können auch mehrere Kontaktlöcher vorhanden sein, um eine sicherere Kontaktierung zu gewährleisten. Das mindestens eine Kontaktloch ist dabei so platziert, dass sowohl von dem Inselgebiet als auch von dem Kontaktgebiet jeweils ein Teil für eine Kontaktierung zugänglich ist. Die in dem mindestens einen Kontaktloch vorgesehene erste Elektrode kontaktiert beide Gebiete ohmsch. Durch die elektrisch leitende Verbindung (= Kurzschluss) zwischen dem Kontaktgebiet und dem Inselgebiet wird eine sich ansonsten zwischen diesen beiden Gebieten ausbildende Kapazität praktisch eliminiert oder zumindest sehr stark reduziert. Dadurch lässt sich der Halbleiteraufbau als sehr schneller Schalter einsetzen.

Eine weitere vorteilhafte Variante des Halbleiteraufbaus ist **dadurch gekennzeichnet, dass** das Inselgebiet in dem an das laterale Kanalgebiet angrenzenden Bereich eine Erhebung aufweist. Diese Erhebung lässt sich beispielsweise durch eine kurze Tiefätzung des Kontaktgebiets und auch des Inselgebiets im nicht an das laterale Kanalgebiet angrenzenden Bereich erreichen. Dadurch dass die zweite Oberfläche im Bereich des Kontaktgebiets gegenüber dem an das Kanalgebiet angrenzenden Bereich des Inselgebiets zurückversetzt ist, erhöht sich die Betriebssicherheit des Halbleiteraufbaus. Das laterale Kanalgebiet wird dann sicher durch die beteiligten Verarmungszonen abgeschnürt, ehe es zu einem möglichen Durchgriff auf das Kontaktgebiet kommen kann.

In einer bevorzugten Ausführungsform ist das laterale Kanalgebiet in vertikaler Richtung zwischen einer ersten und einer zweiten Verarmungszone angeordnet. Die erste Verarmungszone befindet sich auf einer der ersten Oberfläche zugewandten Seite des lateralen Kanalgebiets und die zweite Verarmungszone auf der dem Inselgebiet zugewandeten Seite des lateralen Kanalgebiets. Die zweite Verarmungszone ist von einem p-n-Übergang zwischen dem ersten Halbleitergebiet und dem vergrabenen Inselgebiet gebildet. Je nach Betriebszustand des Halbleiteraufbaus begrenzen die beiden Verarmungszonen das laterale Kanalgebiet oder schnüren es komplett ab. Mit einem derartig ausgebildeten lateralen Kanalgebiet erhält man einen sehr durchbruchsfesten Halbleiteraufbau.

Bevorzugt ist weiterhin eine Ausführungsform, bei der sich die erste Verarmungszone und das Kontaktgebiet in einer senkrecht zur ersten oder zweiten Oberfläche vorgenommenen fiktiven Projektion in eine gemeinsame Ebene an ihren lateralen (= seitlichen) Rändern überlappen. Das laterale Kanalgebiet reicht dann unmittelbar bis an das in das Inselgebiet eingebettete Kontaktgebiet heran. Ein durch die Verarmungszonen nicht steuerbarer Vorkanal, der den Durchlasswiderstand erhöhen würde, bildet sich dann nicht aus.

Die erste Verarmungszone ist bei einer Ausführungsform die eines Schottky-Kontakts. Der Schottky-Kontakt kann dabei insbesondere auch mit der ersten Elektrode und einem an der ersten Oberfläche liegenden Bereich des ersten Halbleitergebiets gebildet sein. Die erste Elektrode erstreckt sich dann über den oberen Rand des Kontaktlochs bis zu dem betreffenden Bereich der ersten Oberfläche. Der Schottky-Kontakt kann aber auch durch eine zusätzliche Steuerelektrode, an die eine Steuerspannung anlegbar ist, und dem an der ersten Oberfläche liegenden Bereich des ersten Halbleitergebiets gebildet sein. In diesem Fall sind die erste Elektrode und die Steuerelektrode elektrisch voneinander isoliert. Das erste Halbleitergebiet kann im Bereich des Schottky-Kontakts eine geeignete, von dem übrigen ersten Halbleitergebiet abweichende Dotierung aufweisen.

Bei einer anderen Ausführungsform ist das laterale Kanalgebiet von wenigstens einer ersten Verarmungszone, die durch einen MIS(Metal Isolator Semiconductor)-Kontakt insbesondere durch einen MOS(Metal Oxide Semiconductor)-Kontakt hervorgerufen wird, begrenzt oder abgeschnürt. Unter einem MIS-Kontakt ist hierbei ein an der ersten Oberfläche des Halbleitergebiets angeordneter Schichtaufbau aus einer Isolationsschicht und einer darüber liegenden Steuerelektrode zu verstehen. Vorzugsweise handelt es sich bei der Isolationsschicht um eine Oxidschicht.

In einer besonders vorteilhaften Ausgestaltung ist die erste Verarmungszone, die das laterale Kanalgebiet in vertikaler Richtung begrenzt, die Verarmungszone eines p-n-Übergangs, der sich zwischen dem ersten Halbleitergebiet und einem zweiten Halbleitergebiet befindet. Das zweite Halbleitergebiet ist an der ersten Oberfläche innerhalb des ersten Halbleitergebiets angeordnet. Es hat den gegenüber dem Leitungstyp des ersten Halbleitergebiets entgegengesetzten Leitungstyp.

Eine erste Variante der Ausgestaltung mit dem zweiten Halbleitergebiet zeichnet sich dadurch aus, dass ein Ladungsspeichereffekt in dem zweiten Halbleitergebiet ausgenutzt wird. Dies wird erreicht durch elektrisches Isolieren des zweiten Halbleitergebiets an der ersten Oberfläche mit einer Isolationsschicht, vorzugsweise mit einer Oxidschicht. Die Ladungsspeicherung im zweiten Halbleitergebiet bewirkt, dass nach Eintritt der Abschnürung des Kanalgebiets bei Anliegen einer bestimmten Betriebsspannung die Abschnürung auch dann zunächst noch anhält, wenn die Betriebsspannung abnimmt. Dadurch wird ein akzeptabler Begrenzungsstrom (Sperrstrom) über eine vorgegebene Begrenzungszeit (Sperrzeit) im Wesentlichen beibehalten. Mit dieser Variante kann ein passiver Strombegrenzer realisiert werden, bei dem das laterale Kanalgebiet normalerweise geöffnet ist und erst durch einen von einem großen Strom hervorgerufenen Spannungsabfall abgeschnürt wird.

In einer zweiten Variante wird das zweite Halbleitergebiet mit einer Steuerelektrode ohmsch kontaktiert. Durch Anlegen einer Steuerspannung an diese Steuerelektrode kann die Ausdehnung der ersten Verarmungszone und damit der elektrische Widerstand des lateralen Kanalgebiets gesteuert werden. In dieser zweiten Variante kann das Kanalgebiet auch bereits im spannungsfreien Zustand abgeschnürt (= normally off) und erst durch Anlegen einer Steuerspannung geöffnet, d. h. erzeugt, werden. Mit diesem steuerbaren Halbleiteraufbau kann ein aktiver Strombegrenzer realisiert werden.

Die erste Elektrode und die Steuerelektrode können elektrisch voneinander isoliert sein. Andererseits ist es auch möglich, mit der ersten Elektrode neben dem Kontaktgebiet und dem Inselgebiet auch das zweite Halbleitergebiet an der ersten Oberfläche ohmsch zu kontaktieren. Das Kontaktgebiet ist dann auch mit dem zweiten Halbleitergebiet elektrisch kurzgeschlossen. Die erste Elektrode und die Steuerelektrode bilden in diesem Fall eine gemeinsame Elektrode.

In einer vorteilhaften Ausgestaltung besteht der Halbleiteraufbau teilweise oder auch komplett aus einem Halbleitermaterial, das einen Bandabstand von wenigstens 2 eV aufweist. Insbesondere wenn ein Ladungsspeichereffekt ausgenutzt wird, ist ein Halbleitermaterial mit so hohem Bandabstand vorteilhaft. Geeignete Halbleitermaterialien sind beispielsweise Diamant, Galliumnitrit (GaN), Indiumphosphit (InP) oder vorzugsweise Siliciumcarbid (SiC). Auf Grund der extrem niedrigen intrinsische Ladungsträgerkonzentration (= Ladungsträgerkonzentration ohne Dotierung) und des sehr geringen Durchlassverlusts sind die genannten Halbleitermaterialien, insbesondere SiC, sehr vorteilhaft. Die niedrige intrinsische Ladungsträgerkonzentration begünstigt eine Ladungsspeicherung. Die genannten Halbleitermaterialien weisen außerdem im Vergleich zu dem "Universalhalbleiter" Silicium eine deutlich höhere Durchbruchsfestigkeit auf, so dass der Halbleiteraufbau bei einer höheren Spannung eingesetzt werden kann. Das bevorzugte Halbleitermaterial ist Siliciumcarbid, insbesondere einkristallines Siliciumcarbid vom 3C- oder 4H- oder 6H- oder 15R-Polytyp.

Günstig ist eine Ausgestaltung, bei der ein zusätzlicher p-n-Übergang zwischen dem ersten Halbleiter-Gebiet und einer zweiten Elektrode, die insbesondere auf einer der ersten Oberfläche gegenüberliegenden Seite des ersten Halbleitergebiets angeordnet ist, vorgesehen ist. Durch diesen zusätzlichen p-n-Übergang kann der Halbleiteraufbau bei einer höheren (Sperr-)Spannung betrieben werden.

Bevorzugte Ausführungsbeispiele werden nunmehr anhand der Zeichnung näher erläutert. Zur Verdeutlichung ist die Zeichnung nicht maßstäblich ausgeführt, und gewisse Merkmale sind schematisiert dargestellt. Im Einzelnen zeigen:
- Figur 1 und Figur 2: einen Halbleiteraufbau mit einem inner- halb eines vergrabenen Inselgebietes angeordneten Kontaktgebiet und einem lateralen Kanalgebiet und
- Figur 3 bis Figur 6: Ausführungsbeispiele zur Steuerung des Kanalgebiets des Halbleiteraufbaus von Figur 1.

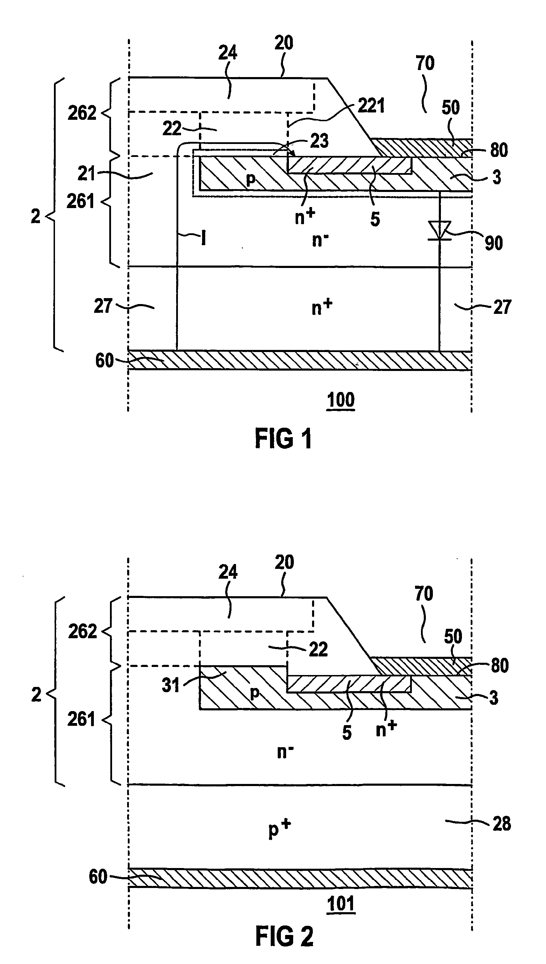

Einander entsprechende Teile sind in den Figuren 1 bis 6 mit denselben Bezugszeichen versehen.

In Figur 1 ist ein Halbleiteraufbau 100 zur Steuerung eines Stroms I in Form eines vertikalen Sperrschichtfeldeffekt-Transistors (JFET) dargestellt. Die in Figur 1 gezeigte Halbleitervorrichtung ist lediglich eine Halbzelle. Durch Spiegelung an dem rechten Rand der Halbzelle erhält man eine komplette Zelle. Eine Mehrzellenstruktur ergibt sich entsprechend durch mehrfache Spiegelung.

Der aktive Teil, in dem die Stromsteuerung im Wesentlichen stattfindet, ist in einem n-leitenden (Elektronenleitung) ersten Halbleitergebiet 2 enthalten. Innerhalb des ersten Halbleitergebiets 2 ist ein p-leitendes (Löcherleitung) vergrabenes Inselgebiet 3 angeordnet. Das erste Halbleitergebiet 2 weist eine erste Oberfläche 20, das vergrabene Inselgebiet 3 eine zweite Oberfläche 80 auf. Beide Oberflächen 20 und 80 laufen im Wesentlichen parallel zueinander. Das erste Halbleitergebiet 2 setzt sich im Ausführungsbeispiel von Figur 1 aus einem Substrat 27 und zwei darauf angeordneten, epitaktisch aufgewachsenen Halbleiterschichten 261 und 262 zusammen. Die erste und die zweite Halbleiterschicht 261 bzw. 262 sind niedriger dotiert (n⁻) als das Substrat 27 (n⁺).

An der zweiten Oberfläche 80 ist ein innerhalb des Inselgebiets 3 eingebettetes n-leitendes Kontaktgebiet 5 vorgesehen. Es ist höher dotiert (n⁺) als die beiden Halbleiterschichten 261 und 262. Das Inselgebiet 3 erstreckt sich in allen Richtungen parallel zur ersten Oberfläche 20 weiter als das Kontaktgebiet 5.

Als Halbleitermaterial kommt in dem Halbleiteraufbau 100 Siliciumcarbid zum Einsatz. Es eignet sich insbesondere bei hohen Spannungen auf Grund seiner spezifischen Materialeigenschaften besonders gut. Bevorzugte Dotierstoffe sind Bor und Aluminium für eine p-Dotierung sowie Stickstoff und Phosphor für eine n-Dotierung. Die Dotierstoffkonzentration des Kontaktgebiets 5 liegt typischerweise zwischen 1 x 10¹⁹ cm⁻³ und 1 x 10²⁰ cm⁻³ und die des ersten Halbleitergebiets 2 typischerweise bei höchstens 2 x 10¹⁶ cm⁻³. Das Zeichen "x' wird hier als Multiplikationssymbol verwendet.

Vorzugsweise werden das vergrabene Inselgebiet 3 und das darin eingebettete Kontaktgebiet 5 nach Aufbringen der ersten Halbleiterschicht 261 hergestellt. Dabei kann insbesondere die in der WO 99/07011 A1 beschriebene selbstjustierende Maskierungstechnik eingesetzt werden. Das Inselgebiet 3 und das Kontaktgebiet 5 werden demgemäß mittels zweier Maskierungsschritte und einer entsprechenden Ionenimplantation von n- und p-Dotierstoffteilchen in die zweite Oberfläche 80 erzeugt. Danach wird in einem zweiten epitaktischen Wachstumsschritt die zweite Halbleiterschicht 262 aufgebracht. Mit der (selbstjustierenden) Herstellung des vergrabenen Inselgebiets 3 und des Kontaktgebiets 5 sind bereits in einem relativ frühen Stadium des Herstellungsprozesses alle Prozessschritte mit einer hohen Anforderung an die Justiergenauigkeit abgearbeitet. Alle folgenden Prozessschritte sind in dieser Hinsicht unkritisch.

Innerhalb der zweiten Halbleiterschicht 262 ist ein Kontaktloch 70 vorgesehen, das sich in vertikaler Richtung bis zu der zweiten Oberfläche 80 des vergrabenen Inselgebiets 3 erstreckt. Das Kontaktloch 70 legt sowohl einen Teil des vergrabenen Inselgebiets 3 als auch einen Teil des Kontaktgebiets 5 frei, so dass beide Gebiete 3 und 5 mittels einer ersten Elektrode 50 aus einem elektrisch leitenden Material ohmsch kontaktiert werden können. Das Kontaktgebiet 5 und das Inselgebiet 3 sind durch die erste Elektrode 50 kurz geschlossen. Als Material für die erste Elektrode 50 kommt Polysilicium oder ein Metall, vorzugsweise Nickel, Aluminium, Tantal, Titan oder Wolfram, in Frage. Das Kontaktloch 70 wird beispielsweise mittels eines Trockenätzprozesses hergestellt. Um Schwankungen in der Ätztiefe auszugleichen, können gemäß einer nicht dargestellten Ausführungsform auch mehrere Kontaktlöcher 70, die dann jeweils einen kleineren Durchmesser aufweisen, vorgesehen sein.

Auf einer von der ersten Oberfläche 20 abgewandten Seite des ersten Halbleitergebiets 2 ist eine zweite Elektrode 60 vorgesehen. Die Zu- und Ableitung des durch den Halbleiteraufbau 100 fließenden Stroms I erfolgt mittels beider Elektroden 50 und 60. Auf Grund des im Wesentlichen vertikalen, d. h. senkrecht zur ersten Oberfläche 20 gerichteten Stromflusses wird auch der Halbleiteraufbau 100 als vertikal bezeichnet.

Seitlich (= lateral) neben dem Kontaktloch 70 ist eine an die erste Oberfläche 20 angrenzende erste Verarmungszone 24 angeordnet, die sich innerhalb des ersten Halbleitergebiets 2 befindet. Weiterhin ist zwischen dem ersten Halbleitergebiet 2 und dem vergrabenen Inselgebiet 3 ein p-n-Übergang vorhanden, dessen Verarmungszone hier als zweite Verarmungszone 23 bezeichnet wird. Die zweite Verarmungszone 23 umgibt das gesamte vergrabene Inselgebiet 3. Soweit sich die beiden Verarmungszonen 23 und 24 innerhalb des ersten Halbleitergebiets 2 erstrecken, sind sie in Figur 1 gestrichelt eingezeichnet. Die erste und die zweite Verarmungszone 24 bzw. 23 begrenzen in vertikaler Richtung ein laterales Kanalgebiet 22 das innerhalb des ersten Halbleitergebiets 2 liegt und Teil des Strompfads zwischen der ersten und der zweiten Elektrode 50 bzw. 60 ist. Die erste Verarmungszone 24 und das vergrabene Inselgebiet 3 sind so angeordnet, dass sich die beiden Verarmungszonen 23 und 24 in einer Projektion auf die erste Oberfläche 20 an ihren seitlichen Rändern überlappen. Das laterale Kanalgebiet 22 befindet sich gerade innerhalb dieses Überlappungsbereichs.

In lateraler Richtung ist das laterale Kanalgebiet 22 auf der dem Kontaktfläche 70 zugewandten Seite durch einen Rand 221 begrenzt. Dieser Rand 221 wird durch eine senkrecht zur ersten oder zweiten Oberfläche 20 bzw. 80 vorgenommene Projektion des Kontaktgebiets 5 in das erste Halbleitergebiet 2 gebildet. Die als untere vertikale Begrenzung dienende zweite Verarmungszone 23 erstreckt sich nämlich ab der Stelle, an der das stark n-dotierte Kontaktgebiet 5 innerhalb des Inselgebiets 3 angeordnet ist, nicht mehr in das erste Halbleitergebiet 2. Der für eine solche Verarmungszone maßgebliche p-n-Übergang verläuft ab dieser Stelle zwischen dem n-leitenden Kontaktgebiet 5 und dem p-leitenden Inselgebiet 3. Der laterale Rand 221 wird damit durch die Lage des Kontaktgebiets 5 innerhalb des Inselgebiets 3 bestimmt. Der in Figur 1 nicht näher bezeichnete zweite laterale Rand des lateralen Kanalgebiets 22 wird dagegen durch die laterale Abmessung des Inselgebiets 5 bestimmt. Diese Geometrieparameter lassen sich durch das in der WO 99/07011 A1 beschriebene Strukturierungsverfahren sehr genau einstellen. Damit ist bei dem Halbleiteraufbau 100 eine hochgenaue Einstellung der Länge und auch Position des lateralen Kanalgebiets 22 möglich.

Die laterale Begrenzung des lateralen Kanals 22 durch das Kontaktgebiet 5 hat außerdem den Vorteil, dass der Strom I unmittelbar nach Austreten aus dem lateralen Kanalgebiet 22 in das Kontaktgebiet 5 eintritt, ohne dabei einen sogenannten Vorkanal innerhalb des ersten Halbleitergebiets 2 zu durchlaufen. Damit entfällt der Widerstand eines solchen Vorkanals und es ergibt sich insgesamt ein niedriger Durchlasswiderstand.

Außerdem führt die Anordnung des Kontaktgebiets und der damit verbundene Wegfall eines Vorkanals zu einem reduzierten Platzbedarf, so dass eine hohe Packungsdichte in einer insbesondere mehrzelligen Halbleiterstruktur, die aus vielen Halbzellen gemäß dem Halbleiteraufbau 100 aufgebaut ist, möglich ist. Auch die Reduzierung der Verlustleistung durch den Wegfall des Vorkanals wirkt sich günstig hinsichtlich einer Erhöhung der Packungsdichte aus.

Die erste Verarmungszone 24 und das Kontaktgebiet 5 sind im Bezug zueinander so angeordnet, dass sie sich in einer senkrecht zur ersten oder zweiten Oberfläche 20 bzw. 80 vorgenommenen Projektion in eine gemeinsame Ebene an ihren seitlichen Rändern um 1 bis 2 µm überlappen. Durch diese letztgenannte Überlappung wird sichergestellt, dass der laterale Rand 221 tatsächlich bis unmittelbar an das Kontaktgebiet 5 heranreicht und sich die vorstehend beschriebenen Vorteile einstellen.

Typischerweise beträgt die Länge (= laterale Ausdehnung) des lateralen Kanalgebiets 22 bei einem aus Siliciumcarbid hergestellten Halbleiteraufbau 100 zwischen 1 µm und 5 µm. Vorzugsweise ist das laterale Kanalgebiet 22 möglichst kurz ausgebildet. Dann ergibt sich ein sehr kompakter Gesamtaufbau mit geringem Platzbedarf. Die vertikale Ausdehnung liegt im spannungs- und stromfreien Zustand typischerweise zwischen 0,1 µm und 1 µm. Die Verarmungszonen 23 und 24 sind durch eine starke Verarmung an Ladungsträgern gekennzeichnet und weisen damit einen wesentlich höheren elektrischen Widerstand auf, als das von ihnen in vertikaler Richtung begrenzte laterale Kanalgebiet 22. Die räumliche Ausdehnung der beiden Verarmungszonen 23 und 24, insbesondere die in vertikaler Richtung, variiert in Abhängigkeit der herrschenden Strom- und Spannungsverhältnisse.

Das laterale Kanalgebiet 22 bestimmt damit maßgeblich das (Steuerungs-)Verhalten des gesamten Halbleiteraufbaus 100. Bei einer Ausbildung als Strombegrenzer hängt das Verhalten bei Anliegen einer Betriebsspannung in Durchlassrichtung (= Vorwärtsrichtung) von dem zwischen den beiden Elektroden 50 und 60 durch den Halbleiteraufbau 100 fließenden elektrischen Strom I ab. Mit steigender Stromstärke wächst auf Grund des Bahnwiderstands der Vorwärtsspannungsabfall zwischen den Elektroden 50 und 60. Dies führt zu einer Vergrößerung der Verarmungszonen 23 und 24 und folglich zu einer mit einer entsprechenden Widerstandserhöhung verbundenen Verminderung der stromtragenden Querschnittsfläche im lateralen Kanalgebiet 22. Bei Erreichen eines bestimmten kritischen Stromwerts (= Sättigungsstrom) berühren sich die beiden Verarmungszonen 23 und 24 und schnüren das laterale Kanalgebiet 22 vollständig ab.

Eine derartige Kanalabschnürung kann auch erreicht werden, indem eine entsprechende Steuerspannung an den Halbleiteraufbau 100 angelegt wird.

Der Strompfad zwischen der ersten und der zweiten Elektrode 50 bzw. 60 umfasst in Vorwärtsrichtung das Kontaktgebiet 5 das laterale Kanalgebiet 22 ein im ersten Halbleitergebiet 2 angeordnetes vertikales Kanalgebiet 21 sowie eine sich danach anschließende Driftzone, die sich aus dem verbleibenden Teil der ersten Epitaxieschicht 261 und dem Substrat 27 zusammensetzt.

Bei Anlegen einer Betriebsspannung in Rückwärtsrichtung erfolgt der Stromfluss dagegen im Wesentlichen über eine Rückwärtsdiode 90, die durch das vergrabene Inselgebiet 3 und den darunter liegenden Teil des ersten Halbleitergebiets 2 gebildet ist. Da der Stromfluss also im Wesentlichen über die Rückwärtsdiode 90 und nicht durch das laterale Kanalgebiet 22 erfolgt, ist in Rückwärtsrichtung keine Stromsteuerung durch den Halbleiteraufbau 100 möglich. Bei Einsatz des Halbleiteraufbaus 100 in einem Umrichter kann die integrierte Rückwärtsdiode 90 die ansonsten in einem Umrichter üblicherweise erforderliche Beschaltung des verwendeten Halbleiterschalters mit einer Freilaufdiode erübrigen. Für die Stromführung in Rückwärtsrichtung bietet die Rückwärtsdiode 90 eine große stromtragfähige Fläche.

Der in Figur 2 gezeigte Halbleiteraufbau 101 unterscheidet sich von dem Halbleiteraufbau 100 lediglich dadurch, dass statt des n-leitenden Substrats 27 ein p-leitendes Substrat 28 verwendet wird. Das schwach n-leitende erste Halbleitergebiet 2, das sich hier nur aus den beiden Halbleiterschichten 261 und 262 zusammensetzt, bildet mit dem stark p-leitenden (p⁺) Substrat 28 einen p-n-Übergang. Dieser zusätzliche p-n-Übergang ist insbesondere bei einem Einsatz bei einer hohen Spannung, die beispielsweise mindestens in der Größenordnung von einigen kV liegt, günstig.

Außerdem weist das vergrabene Inselgebiet 3 im an das laterale Kanalgebiet 22 angrenzenden Bereich eine zusätzliche Erhebung 31 auf. Die Erhebung 31 entsteht beispielsweise durch einen kurzen Tiefätzschritt nach der Herstellung des Inselgebiets 3 und des eingebetteten Kontaktgebiets 5 noch vor dem epitaktischen Wachstum der zweiten Halbleiterschicht 262. Die Tiefätzung erfolgt nur in dem Bereich der zweiten Oberfläche 80, die nicht an das laterale Halbleitergebiet 22 angrenzt, also insbesondere auch im Bereich des Kontaktgebiets 5. Durch diese Maßnahme ergibt sich ein sicheres Betriebsverhalten. Die Abschnürung des lateralen Kanalgebiets 22 durch die beiden Verarmungszonen 23 und 24 erfolgt dann nämlich sicher vor einem ansonsten prinzipiell möglichen unerwünschten Durchgriff der Verarmungszone 24 auf das Kontaktgebiet 5. Die Maßnahme, eine Erhebung 31 in dem Inselgebiet 3 vorzusehen, lässt sich ohne Weiteres auch auf den Halbleiteraufbau 100 von Figur 1 übertragen.

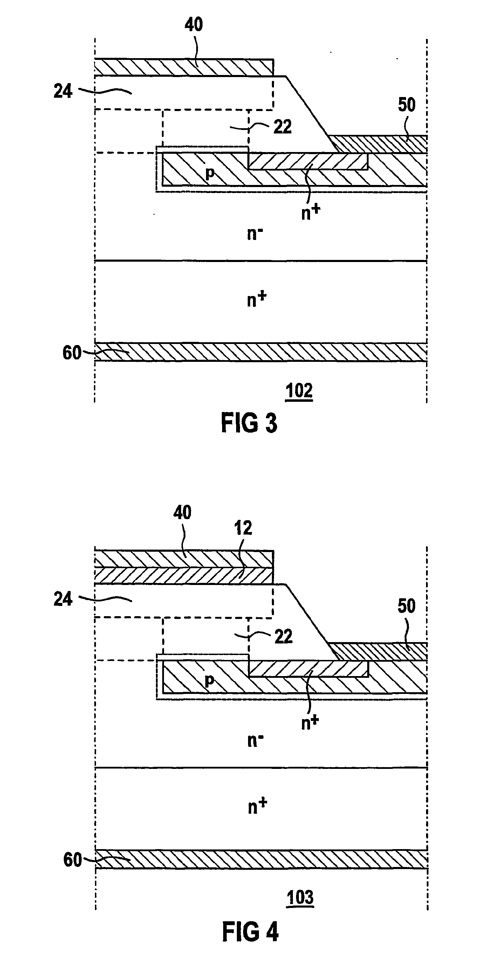

Die vorstehend beschriebene Abschnürung des lateralen Kanalgebiets 22 kann außer durch den Strommechanismus auch durch eine Steuerspannung, die insbesondere die räumliche Ausdehnung der ersten Verarmungszone 24 beeinflusst, erreicht werden. Die Ausführungsbeispiele der Figuren 3 bis 6 beziehen sich auf solche speziellen Ausgestaltungen der ersten Verarmungszone 24 zur Steuerung des Kanalgebiets 22. Die Ausgestaltungen sind jeweils am Beispiel des Halbleiteraufbaus 100 von Figur 1 dargestellt. Alle Ausgestaltungen lassen sich analog auch auf den Halbleiteraufbau 101 von Figur 2 übertragen.

In dem Ausführungsbeispiel gemäß Figur 3 wird die erste Raumladungszone 24 durch einen Schottky-Kontakt hervorgerufen. Dazu befindet sich direkt auf der ersten Oberfläche 20 eine Steuerelektrode 40. Durch Anlegen einer entsprechenden Steuerspannung an die Steuerelektrode 40 wird die erste Raumladungszone 24 und damit das laterale Kanalgebiet 22 in seiner vertikalen Ausdehnung beeinflusst.

Wenn keine gesonderte Beeinflussung der ersten Verarmungszone 24 durch eine Steuerspannung erforderlich ist, kann die Steuerelektrode 40 auch mit der ersten Elektrode 50 kurzgeschlossen sein. Es ergibt sich dadurch eine in Figur 3 nicht dargestellte gemeinsame Elektrode. Mit einer Möglichkeit zur Beeinflussung durch eine externe Steuerspannung ergibt sich ein aktiver Halbleiteraufbau 102. Mit einer gemeinsamen Elektrode aus Steuerelektrode 40 und erster Elektrode 50 erhält man dagegen einen passiven Halbleiteraufbau 102. Ein geeignetes Material für die gemeinsame Elektrode ist Nickel.

Bei einem weiteren Halbleiteraufbau 103 nach Figur 4 wird die erste Verarmungszone 24 durch einen MOS(Metal Oxide Semiconductor)-Kontakt hervorgerufen. Dazu befindet sich direkt auf der ersten Oberfläche 20 eine Isolationsschicht 12 in Form einer Oxidschicht. Darauf ist eine Steuerelektrode 40 angeordnet, durch die die erste Verarmungszone 24 wiederum gesteuert werden kann.

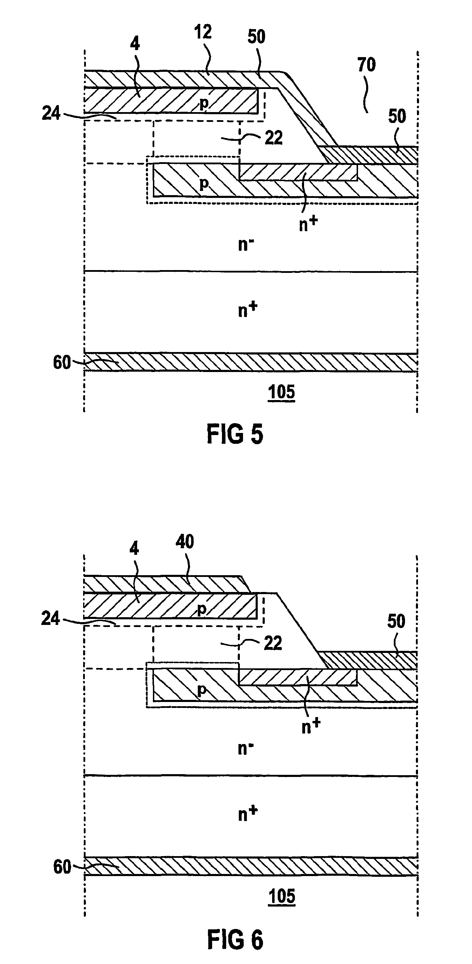

In den Figuren 5 und 6 sind dagegen ein Halbleiteraufbau 104 bzw. ein Halbleiteraufbau 105 dargestellt, bei denen an der ersten Oberfläche 20 innerhalb des ersten Halbleitergebiets 2 jeweils ein zweites Halbleitergebiet 4 angeordnet ist. Dieses hat den gegenüber dem Leitungstyp des ersten Halbleitergebiets 2 entgegengesetzten Leitungstyp, also in den dargestellten Ausführungsbeispielen den p-Leitungstyp. Es wird ebenfalls vorzugsweise durch Ionenimplantation erzeugt. Das zweite Halbleitergebiet 4 ist insbesondere stark p-dotiert (p⁺). Zwischen dem ersten Halbleitergebiet 2 und dem zweiten Halbleitergebiet 4 ist dann ein p-n-Übergang vorhanden, dessen Verarmungszone hier die erste Verarmungszone 24 bildet.

Bei dem Halbleiteraufbau 104 nach Figur 5 erstreckt sich auf der Oberfläche 20 eine Schicht, die sich durchgehend vom zweiten Halbleitergebiet 4 bis hin zu der ersten Elektrode 50 innerhalb des Kontaktlochs 70 erstreckt. Hierbei sind zwei verschiedene Ausführungsformen voneinander zu unterscheiden. In der ersten Ausführungsform besteht die Schicht aus elektrisch isolierendem und in der zweiten Ausführungsform aus leitfähigem Material. In beiden Fällen ergibt sich ein passiver Halbleiteraufbau 104, der von Außen nicht gezielt, beispielsweise durch Anlegen einer Steuerspannung, gesteuert werden kann.

In der ersten Ausführungsform ist auf der ersten Oberfläche 20 eine Isolationsschicht 12 angeordnet, die das zweite Halbleitergebiet 4 elektrisch isoliert und damit ein Abfließen von aus dem zweiten Halbleitergebiet 4 in die erste Verarmungszone 24 diffundierten Ladungen (im dargestellten Fall Elektronen) verhindert. Der Leckstrom der Isolationsschicht 12 sollte möglichst gering sein, um eine gute Ladungsspeicherung im zweiten Halbleitergebiet 4 zu gewährleisten. Eine weitere Funktion der Isolationsschicht 12 ist die elektrische Isolation des zweiten Halbleitergebiets 4 von der ersten Elektrode 50. Als Material wird für die Isolationsschicht 12 ein Oxid vorzugsweise ein thermisch gewachsenes Siliciumdioxid (SiO₂) verwendet. Thermisches SiO₂ weist sehr gute Isolationseigenschaften auf und kann auf SiC durch Trocken- oder Nassoxidation bei Temperaturen über 1000 °C erzeugt werden.

In der zweiten Ausführungsform des Halbleiteraufbaus 104 von Figur 5 erstreckt sich die erste Elektrode 50 auch bis zum zweiten Halbleitergebiet 4 und kontaktiert diese ebenfalls ohmsch. Das zweite Halbleitergebiet 4 und das Kontaktgebiet 5 sowie das vergrabene Inselgebiet 3 sind dann mittels der ersten Elektrode 50 elektrisch leitend, d. h. niederohmig, miteinander verbunden.

Im Gegensatz zu den beiden passiven (nicht steuerbaren) Ausführungsformen des Halbleiteraufbaus 104 gemäß Figur 5 ist in Figur 6 ein aktiver (steuerbarer) Halbleiteraufbau 105 dargestellt. Dazu ist auf dem zweiten Halbleitergebiet 4 eine gesonderte Steuerelektrode 40 vorgesehen. Damit kann man durch Anlegen eines Steuerpotenzials an die Steuerelektrode 40 die Ausdehnung der ersten Verarmungszone 24 unabhängig von einem an der ersten Elektrode 50 anstehenden Potenzial verändern. Die Leitfähigkeit des lateralen Kanalgebiets 22 lässt sich folglich in diesem Ausführungsbeispiel aktiv steuern.

Ein aktiver, d.h. ein durch eine externe Steuerspannung beeinflussbarer Halbleiteraufbau 102, 103 oder 105 kann mit besonderem Vorteil in einer aus der DE 196 10 135 C1 bekannten Kaskodeschaltung aus einem Niederspannungs-Schaltelement mit einem Hochspannungs-Schaltelement eingesetzt werden. Der dann verwendete Halbleiteraufbau 102, 103 oder 105 bildet dabei das Hochspannungs-Schaltelement. Damit erhält man eine Gesamtschaltung, die sich mit einer nur sehr geringen Steuerspannung (in der Größenordnung einiger Volt) von einem stromführenden in einen stromsperrenden Zustand schalten lässt und dabei gleichzeitig die anstehende Betriebsspannung im stromsperrenden Zustand sicher aufnehmen kann. Der verwendete aktive Halbleiteraufbau 102, 103 oder 105 ermöglicht ein sehr robustes und insbesondere auch sehr schnelles Umschalten von dem Strom leitenden in den Strom sperrenden Zustand.

## Patentansprüche

1. Halbleiteraufbau zur Steuerung eines zwischen einer ersten und einer zweiten Elektrode (50, 60) fließenden Stroms (I), wobei der Halbleiteraufbau aufweist:
a) ein erstes Halbleitergebiet (2) eines ersten Leitungstyps (n oder p) mit einer ersten Oberfläche (20);
b) ein innerhalb des ersten Halbleitergebiets (2) zumindest teilweise vergrabenes Inselgebiet (3) eines zweiten gegenüber dem ersten Leistungstyp entgegengesetzten, Leitungstyps (p oder n) mit einer der ersten Oberfläche (20) zugewandten zweiten Oberfläche (80);
c) ein Kontaktgebiet (5) des ersten Leitungstyps (n oder p), wobei die erste Elektrode (50) sowohl das Kontaktgebiet (5) als auch das Inselgebiet (3) kontaktiert und die zweite Elektrode (60) auf einer der ersten Elektrode (50) gegenüberliegenden Oberfläche des ersten Halbleitergebiets (2) angeordnet ist;
d) ein Mittel (40, 40/12, 12/50/4, 40/4) zur Erzeugung einer ersten Verarmungszone (24) innerhalb des ersten Halbleitergebiets (2) wobei dieses Mittel (40, 40/12, 12/50/4, 40/4) das Inselgebiet (3) in lateraler Richtung teilweise überlappt, im ersten Halbleitergebiet (2) ein zwischen erster und zweiter Oberfläche (20, 80) als Teil des ersten Halbleitergebiets ausgebildetes laterales Kanalgebiet (22) als Teil des Strompfades zwischen erster und zweiter Elektrode (50,60) entsteht und die erste Verarmungszone (24) und eine sich vom Inselgebiet (3) in das erste Halbleitergebiet (2) hinein erstreckenden zweite Verarmungszone (23) das laterale Kanalgebiet (22) jeweils in vertikaler Richtung begrenzen oder abschnüren,
e) das Kontaktgebiet (5) an der zweiten Oberfläche (80) in das Inselgebiet (3) eingebettet und dort derart angeordnet ist, dass sich das Kontaktgebiet (5) und das Mittel (40, 40/12, 12/50/4, 40/4) zur Erzeugung der ersten Verarmungszone (24) in laterater Richtung teilweise überlappen.

2. Halbleiteraufbau nach Patentanspruch 1,
**dadurch gekennzeichnet, dass**
das erste Halbleitergebiet (2) ein Substrat (27) des ersten oder zweiten Leistungstyps (n oder p), eine auf dem Substrat (27) angeordnete erste Halbleiterschicht (261) des ersten Leistungstyps (n oder p) sowie eine äußere zweite Halbleiterschicht (262) des ersten Leitungstyps (n oder p) aufweist, wobei das Inselgebiet (3) und das darin eingebettete Kontaktgebiet (5) in der substratseitigen ersten Halbleiterschicht (261) angeordnet sind.

3. Halbleiteraufbau nach Patentanspruch 1 oder 2,
**dadurch gekennzeichnet,**
**dass** die erste Elektrode (50) innerhalb eines sowohl einen Teil des vergrabenen Inselgebiets (3) als auch einen Teil des Kontaktsgebiets (5) freiliegenden Kontaktsloches (70) angeordnet ist.

4. Halbleiteraufbau nach einem der Patentansprüche 1 bis 3,
**dadurch gekennzeichnet,**
**dass** das Mittel (40, 40/12, 12/50/4, 40/4) zur Erzeugung der ersten Verarmungszone (24) auf einer ersten Oberfläche (20) des ersten Halbleitergebiets (2) oder auf einer ersten Oberfläche (20) der äußeren zweiten Halbleiterschicht (262) angeordnet ist.

5. Halbleiteraufbau nach Anspruch 4,
**dadurch gekennzeichnet,**
**dass** das Mittel (40,40/12, 12/50/4, 40/4) zur Erzeugung der ersten Verarmungszone (24) eine dritte Elektrode (40) aufweist, wobei die dritte Elektrode (40) unmittelbar auf der ersten Oberfläche (20) angeordnet oder durch eine erste Isolationsschicht (12) von der ersten Oberfläche (20) getrennt ist.

6. Halbleiteraufbau nach Patentanspruch 5,
**dadurch gekennzeichnet,**
**dass** ein an der ersten Oberfläche (20) angeordnetes zweites Halbleitergebiet (4) des zweiten Leistungstyps (p oder n) von der dritten Elektrode (40) ohmsch kontaktiert oder von einer zweiten Isolierschicht (12) abgedeckt ist.

7. Halbleiteraufbau nach Patentanspruch 5 oder 6,
**dadurch gekennzeichnet,**
**dass** die erste Elektrode (50) und die dritte Elektrode (40) elektrisch leitend miteinander verbunden sind.

8. Halbleiteraufbau nach Patentanspruch 5 oder 6,
**dadurch gekennzeichnete**
**dass** sich die zweite Isolationsschicht (12) auf der ersten Oberfläche (20) durchgehend bis zur ersten Elektrode (50) hin erstreckt.

9. Halbleiteraufbau nach einem der Ansprüche 1 bis 8,
**gekennzeichnet durch**
ein Halbleitermaterial, dessen Bandabstand mindestens 2eV beträgt.

10. Halbleiteraufbau nach Anspruch 9,
**gekennzeichnet durch**
SiC als Halbleitermaterial.

## Claims

1. Semiconductor construction for controlling a current (I) flowing between a first and a second electrode (50, 60), wherein the semiconductor construction comprises:
a) a first semiconductor region (2) of a first conduction type (n or p) having a first surface (20);
b) an island region (3) of a second conduction type (p or n), opposite to the first conduction type, which is at least partly buried within the first semiconductor region (2) and has a second surface (80) facing the first surface (20);
c) a contact region (5) of the first conduction type (n or p), wherein the first electrode (50) makes contact with both the contact region (5) and the island region (3), and the second electrode (60) is arranged on a surface of the first semiconductor region (2) which lies opposite the first electrode (50);
d) a means (40, 40/12, 12/50/4, 40/4) for producing a first depletion zone (24) within the first semiconductor region (2), wherein said means (40, 40/12, 12/50/4, 40/4) partly overlaps the island region (3) in a lateral direction, in the first semiconductor region (2) a lateral channel region (22) embodied between the first and second surfaces (20, 80) as part of the first semiconductor region arises as part of the current path between the first and second electrodes (50, 60) and the first depletion zone (24) and a second depletion zone (23), which extends from the island region (3) into the first semiconductor region (2), bound or pinch off the lateral channel region (22) in each case in a vertical direction, and wherein
e) the contact region (5) is embedded into the island region (3) at the second surface (80) and is arranged there in such a way that the contact region (5) and the means (40, 40/12, 12/50/4, 40/4) for producing the first depletion zone (24) partly overlap in a lateral direction.

2. Semiconductor construction according to Patent Claim 1,
**characterized in that**
the first semiconductor region (2) has a substrate (27) of the first or second conduction type (n or p), a first semiconductor layer (261) of the first conduction type (n or p), which is arranged on the substrate (27), and also an outer second semiconductor layer (262) of the first conduction type (n or p), wherein the island region (3) and the contact region (5) embedded therein are arranged in the substrate-side first semiconductor layer (261).

3. Semiconductor construction according to Patent Claim 1 or 2,
**characterized**
**in that** the first electrode (50) is arranged within a contact hole (70) that exposes both part of the buried island region (3) and part of the contact region (5).

4. Semiconductor construction according to any of Patent Claims 1 to 3,
**characterized**
**in that** the means (40, 40/12, 12/50/4, 40/4) for producing the first depletion zone (24) is arranged on a first surface (20) of the first semiconductor region (2) or on a first surface (20) of the outer second semiconductor layer (262).

5. Semiconductor construction according to Claim 4,
**characterized**
**in that** the means (40, 40/12, 12/50/4, 40/4) for producing the first depletion zone (24) has a third electrode (40), wherein the third electrode (40) is arranged directly on the first surface (20) or is isolated from the first surface (20) by a first insulation layer (12).

6. Semiconductor construction according to Patent Claim 5,
**characterized**
**in that** a second semiconductor region (4) of the second conduction type (p or n), which is arranged at the first surface (20), is subjected to ohmic contact-connection by the third electrode (40) or is covered by a second insulating layer (12).

7. Semiconductor construction according to Patent Claim 5 or 6,
**characterized**
**in that** the first electrode (50) and the third electrode (40) are electrically conductively connected to one another.

8. Semiconductor construction according to Patent Claim 5 or 6,
**characterized**
**in that** the second insulation layer (12) extends on the first surface (20) continuously as far as the first electrode (50).

9. Semiconductor construction according to any of Claims 1 to 8,
**characterized by**
a semiconductor material having a band gap of at least 2eV.

10. Semiconductor construction according to Claim 9,
**characterized by**
SiC as semiconductor material.

## Revendications

1. Structure à semi-conducteurs pour la commande d'un courant (I) circulant entre une première et une seconde électrodes (50, 60), la structure à semi-conducteurs présentant :
a) une première zone à semi-conducteurs (2) d'un premier type de conductivité (n ou p) avec une première surface (20)
b) une zone d'îlot (3), enterrée au moins en partie à l'intérieur de la première zone à semi-conducteurs (2), d'un second type de conductivité (p ou n) opposé par rapport au premier type de conductivité, avec une seconde surface (80) tournée vers la première surface (20) ;
c) une zone de contact (5) du premier type de conductivité (n ou p), la première électrode (50) établissant un contact aussi bien avec la zone de contact (5) qu'avec la zone d'îlot (3) et la seconde électrode (60) étant disposée sur une surface, opposée à la première électrode (50), de la première zone à semi-conducteurs (2) ;
d) un moyen (40, 40/12, 12/50/4, 40/4) pour générer une première zone d'appauvrissement (24) à l'intérieur de la première zone à semi-conducteurs (2), ce moyen (40, 40/12, 12/50/4, 40/4) recouvrant partiellement la zone d'îlot (3) dans la direction latérale, une zone de canal (22) latérale, conçue entre la première et la seconde surfaces (20, 80) comme partie de la première zone à semi-conducteurs se formant dans la première zone à semi-conducteurs (2) en tant que partie du trajet de courant entre la première et la seconde électrodes (50, 60) et la première zone d'appauvrissement (24) et une seconde zone d'appauvrissement (23) s'étendant depuis la zone d'îlot (3) à l'intérieur de la première zone à semi-conducteurs (2) délimitant ou rétrécissant la zone de canal (22) latérale à chaque fois dans la direction verticale, et
e) la zone de contact (5) sur la seconde surface (80) étant enchâssée dans la zone d'îlot (3) et disposée ici de telle sorte que la zone de contact (5) et le moyen (40, 40/12, 12/50/4, 40/4) se chevauchent partiellement dans la direction latérale pour générer la première zone d'appauvrissement (24).

2. Structure à semi-conducteurs selon la revendication 1,
**caractérisée en ce que** la première zone à semi-conducteurs (2) présente un substrat (27) du premier ou du second type de conductivité (n ou p), une première couche à semi-conducteurs (261) disposée sur le substrat (27), du premier type de conductivité (n ou p) et une seconde couche à semi-conducteurs (262) extérieure du premier type de conductivité (n ou p), la zone d'îlot (3) et la zone de contact (5) enchâssée à l'intérieur étant disposées dans la première couche à semi-conducteurs (261) côté substrat.

3. Structure à semi-conducteurs selon la revendication 1 ou 2,
**caractérisée en ce que** la première électrode (50) est disposée à l'intérieur d'un trou de contact (70) libérant aussi bien une partie de la zone d'îlot (3) enterrée qu'une partie de la zone de contact (5).

4. Structure à semi-conducteurs selon l'une quelconque des revendications 1 à 3,
**caractérisée en ce que** le moyen (40, 40/12, 12/50/4, 40/4) pour générer la première zone d'appauvrissement (24) est disposé sur une première surface (20) de la première zone à semi-conducteurs (2) ou sur une première surface (20) de la seconde couche à semi-conducteurs (262) extérieure.

5. Structure à semi-conducteurs selon la revendication 4,
**caractérisée en ce que** le moyen (40, 40/12, 12/50/4, 40/4) pour générer la première zone d'appauvrissement (24) présente une troisième électrode (40), la troisième électrode (40) étant disposée directement sur la première surface (20) ou étant séparée par une première couche d'isolation (12) de la première surface (20).

6. Structure à semi-conducteurs selon la revendication 5,
**caractérisée en ce qu'**une seconde zone à semi-conducteurs (4), disposée sur la première surface 20, du second type de conductivité (p ou n) est mise en contact au plan ohmique par la troisième électrode (40) ou est recouverte par une seconde couche isolante (12).

7. Structure à semi-conducteurs selon la revendication 5 ou 6,
**caractérisée en ce que** la première électrode (50) et la troisième électrode (40) sont reliées entre elles de façon électroconductrice.

8. Structure à semi-conducteurs selon la revendication 5 ou 6,
**caractérisée en ce que** la seconde couche d'isolation (12) s'étend sur la première surface (20) de façon continue jusqu'à la première électrode (50).

9. Structure à semi-conducteurs selon l'une quelconque des revendications 1 à 8,
**caractérisée par** un matériau semi-conducteur, dont la largeur de bande interdite est d'au moins 2 eV.

10. Structure à semi-conducteurs selon la revendication 9,
**caractérisée par** du SiC comme matériau semi-conducteur.
